# EUROPÄISCHE PATENTSCHRIFT

(11) **EP 2 024 992 B1**
(45) Veröffentlichungstag und Bekanntmachung des Hinweises auf die Patenterteilung: **01.03.2017**
(21) Anmeldenummer: 06762845.3
(22) Anmeldetag: 26.07.2006
(51) Int. Cl.: H01L 21/304, H01L 21/306, C09G 1/02, C09K 3/14

(54) **VERFAHREN ZUM GLÄTTEN VON III-N-SUBSTRATEN**
METHOD FOR SMOOTHING III-N SUBSTRATES
PROCEDE DE LISSAGE DE SUBSTRATS III-N

(43) Veröffentlichungstag der Anmeldung: 18.02.2009
(60) Teilanmeldung: 16201978.0
(73) Patentinhaber: Freiberger Compound Materials GmbH, 09599 Freiberg (DE)
(72) Erfinder: HÖLZIG, Stefan, 09599 Freiberg (DE); LEIBIGER, Gunnar, 09599 Freiberg (DE)
(74) Vertreter: Prüfer & Partner mbB Patentanwälte · Rechtsanwälte
(86) Internationale Anmeldenummer: PCT/EP2006/007413
(87) Internationale Veröffentlichungsnummer: WO 2008/011897

(56) Entgegenhaltungen:
- EP-A2- 1 431 426
- WO-A-2006/075527
- JP-A- 2006 060 074
- US-A1- 2002 185 054
- WEYHER J L ET AL: "Chemical polishing of bulk and epitaxial GaN" JOURNAL OF CRYSTAL GROWTH, ELSEVIER, AMSTERDAM, NL, Bd. 182, Nr. 1-2, Dezember 1997 (1997-12), Seiten 17-22, XP004100368 ISSN: 0022-0248 in der Anmeldung erwähnt
- MISKYS C R ET AL: "MOCVD-EPITAXY ON FREE-STANDING HVPE-GAN SUBSTRATES", PHYSICA STATUS SOLIDI (A). APPLIED RESEARCH, BERLIN, DE, vol. 176, no. 1, 4 July 1999 (1999-07-04), pages 443-446, XP009049524, ISSN: 0031-8965, DOI: 10.1002/(SICI)1521-396X(199911)176:1<443:: AID-PSSA443>3.0.CO;2-Q

## Beschreibung

Die vorliegende Erfindung bezieht sich auf ein Verfahren zum Herstellen einer geglätteten Oberfläche eines Materials, das an der zu glättenden Oberfläche eine III-N-Verbindung umfaßt, wobei III mindestens ein Element der Gruppe III. des Periodensystems bedeutet, ausgewählt aus Al, Ga und In, wobei das Verfahren einen Polierprozess der Oberfläche des III-N-Materials einschließt.

Mechanisches und/oder chemisch-mechanisches Polieren ist seit längerer Zeit ein gewerblich verwendetes Standardverfahren zum Einebnen und Glätten der Oberflächen von Halbleitersubstraten, wie beispielsweise von GaAs. Dabei sind glatte und ebene sowie störungsfreie Substratoberflächen Voraussetzung für nachfolgende Epitaxie- oder Lithographieschritte zur Herstellung von mikro- oder optoelektronischen Bauelementen. Bekannte Polierverfahren für GaN-Substrate mit c-Ebenen-Orientierung unterscheiden sich auf Grund der unterschiedlichen chemischen Stabilität für die Ga-polare ([0001]-Orientierung) und die N-polare ([0001̅]-Orientierung) Oberfläche. So ist die Ga-Fläche (d.h. (0001)) bei Raumtemperatur nahezu chemisch inert, während die N-Fläche (d.h. (0001̅)) von verschiedenen Ätzmitteln (beispielsweise wässrige NaOH- oder KOH-Lösungen) angegriffen wird. Darüber hinaus ist die Ga-Fläche deutlich härter als die N-Fläche. Weyher et al. ("Chemical polishing of bulk and epitaxial GaN", J. Cryst. Growth 182 (1997) 17) stellten ein Polierverfahren für das Polieren der N-Fläche vor (Anmerkung: Eine Zuordnung der Ergebnisse zur N- bzw. Ga-Fläche erfolgte später, siehe z.B. J. Weyer et al., "Defects in GaN single crystals and homoepitaxial structures", J. Cryst. Growth 281 (2005) 135), welches aus einem mechanischen Polierschritt unter Benutzung von Diamant-Slurry und einem anschließenden CMP-Schritt unter Benutzung einer wässrigen Lösung aus KOH und/oder NaOH besteht. Für die anschließende Epitaxie ist jedoch die Ga-Fläche, für welche das angegebene Verfahren nicht anwendbar ist, von ungleich größerer Bedeutung (siehe z.B. Miskys et al., "MOCVD-Epitaxy on Free-Standing HVPE-GaN Substrates", phys. stat. sol. (a) 176 (1999) 443). Das verwendete Hartmaterial für die abrasiven Teilchen wurde von Weyher et al. nicht angegeben.

Das von Porowski et al. ("Mechano-chemical polishing of crystals and epitaxial layers of GaN and Gal-x-yAlxInyN", US 6,399,500) angegebene Verfahren entspricht dem vorstehend genannten Stand der Technik von Weyher et al.. Ein expliziter Hinweis auf die Polarität der polierten Fläche ist nicht gegeben. Das verwendete Hartmaterial für die abrasiven Teilchen wurde nicht angegeben.
Tavernier et al. ("Chemical Mechanical Polishing of Gallium Nitride", Electrochemical and Solid-State Letters 5 (2002) G61) berichten von einem CMP-Prozess unter Benutzung von Siliziumoxid als abrasives Teilchen, der ebenfalls nur für die N-Fläche von GaN erfolgreich angewandt werden konnte, für die Ga-Fläche jedoch ungeeignet ist.

Karouta et al. ("Final polishing of Ga-polar GaN substrates using reactive ion etching", Journal of Electronic Materials 28 (1999) 1448) stellten ein Verfahren zum Polieren der Ga-Fläche von GaN mittels reaktivem Ionenstrahlätzen (RIE) vor, wobei die Kristalle in einem vorangehenden mechanischen Polierschritt mit Diamantslurry vorbehandelt wurden.
Das RIE-Verfahren hat zum einen den Nachteil, dass es sehr aufwendig ist und andererseits durch die Ionenbestrahlung zu einer Schädigung des Kristallgitters im oberflächennahen Bereich führt.
Kim et al. ("Method for fabricating GaN substrate", US 6,211,089) berichten von einem Verfahren zum Polieren von GaN-Substraten, bestehend aus mechanischen Polierschritten mit Diamant-Slurry und Borkarbid-Platten, wobei zum Beseitigen der Polierschäden ebenfalls ein RIE-Prozess mit den obengenannten Nachteilen sowie darüber hinaus ein thermischer Ausheilschritt verwendet wird.
Xu et al. ("High surface quality GaN wafer and method of fabricating same", US 6,951,695) beschreiben eine Methode zum chemisch-mechanischen Polieren u.a. von AlₓGa_{y}ln_{z}-terminierten (0001) - AlₓGa_{y}In_{z}N-Oberflächen unter Verwendung abrasiver Siliziumoxid- oder Aluminiumoxidteilchen in saurer oder basischer Lösung. Aus der Beschreibung geht ferner hervor, dass die vorzugsweise unter Verwendung von Diamant-Slurry (oder alternativ Siliziumkarbid-, Borkarbid- oder Aluminiumoxid-Slurry) durch das mechanische Polieren, welches dem CMP-Schritt vorangestellt ist sowie durch den CMP-Prozess verursachten strukturellen Schäden im Kristall durch einen nachfolgenden nasschemischen Ätzschritt beispielsweise unter Verwendung von 180°C heißer Phosphorsäure beseitigt bzw. minimiert werden, was technologisch aufwendig ist.

Kato et al. ("Polishing composition for semiconductor substrate and method of manufacturing semiconductor substrate using same", JP-Anmeldung 2003-100373) beschreiben eine Slurryzusammensetzung hauptsächlich zum Polieren von GaN, die aus einer Mischung aus harten (z.B. Diamant) und weichen (z.B. Siliziumoxid) abrasiven Teilchen besteht. In dem beschriebenen Polierverfahren wird die Slurry auf einer Temperatur zwischen 10°C und 80°C gehalten. Das Polieren bei erhöhter Temperatur ist technologisch sehr aufwendig.

WO 2006/075527 A beschreibt ein Verfahren zum Herstellen einer geglätteten Oberfläche eines Materials, das an der zu glättenden Oberfläche eine Ga-N-Verbindung umfasst, wobei das Verfahren einen Polierprozess der Oberfläche des Ga-N-Materials einschließt.

Der vorliegenden Erfindung liegt die Aufgabe zugrunde, ein Verfahren zum Glätten, insbesondere zum Polieren von III-N-Oberflächen bereitzustellen, das zum einen auch auf eine chemisch nahezu inerte Fläche des III-N-Kristalls [d.h. die (AI,Ga,In)-Fläche] erfolgreich anwendbar ist und zum anderen das Kristallgitter möglichst wenig schädigt, um damit ein III-N-Substrat und ein III-N-Template mit jeweils verbesserter Oberflächenstruktur bereitstellen zu können.

Die Aufgabe wird gelöst durch ein Verfahren gemäß Patentanspruch 1. In diesem Verfahren wird eine geglättete Oberfläche eines Materials hergestellt, das an der zu glättenden Oberfläche eine III-N-Verbindung umfaßt, bei dem kubisches Bornitrid (cBN) als abrasives Teilchenmaterial verwendet wird. Der Glättungsprozeß schließt einen Polierprozess und ggf. einen Läppprozess einer Oberfläche von III-N-Material ein. Es wurde überraschend gefunden, daß speziell mit dem Teilchenmaterial cBN einerseits eine Wirkung auf die chemisch nahezu inerte und harte (Al,Ga,In)-Fläche von (Al,Ga,In)N erreicht wird, andererseits aber eine Schädigung des Kristallgitters reduziert wird. Der Grund wird darin vermutet, daß kubisches Bornitrid (cBN) eine speziell zum Polieren von III-N-Material optimale Härte aufweist, mit der gegenläufige Wirkungen am besten vereinigt werden. Dieses cBN-Material ist härter als beispielsweise Siliziumoxid, so dass beim Polieren ein merklicher Abtrag auch auf der chemisch nahezu inerten und harten (Al,Ga,In)-Fläche zu erreichen ist. Andererseits ist es aber weniger hart als Diamant, was eine Schädigung des Kristallgitters reduziert. Die Effizienz und die Wirkungen beim Polierprozeß können verbessert werden, wenn der Polierprozess mehrere Schritte aufweist bei denen in jeweils nachfolgenden Schritten die mittlere Korngröße der kubischen Bornitridteilchen abnimmt, insbesondere bevorzugt 2, 3, 4, 5 oder 6 Polierschritte. Eine besonders gute Kombination von Polierschritten besteht darin, dass in zwei und vorzugsweise in drei aufeinanderfolgenden Schritten die mittleren Korngrößen des cBN jeweils über 4 bis 7 µm (1. Stufe), 2 bis unter 4 µm (2. Stufe) und 0,5 bis unter 2 µm (ggf. 3. Stufe) betragen, insbesondere wenn die mittleren Korngrößen jeweils etwa 6 µm, etwa 3 µm und etwa 1 µm betragen, wobei der Ausdruck "etwa" eine Toleranz von ± 0.5 µm bedeutet.

Es sei angemerkt, daß Keizo et al. in JP-A-2001-085373 eine CMP-Polierflüssigkeit beschreiben, die als abrasives Teilchenmaterial zum Bespiel Siliziumoxid, Siliziumnitrid, Aluminium, Zirkoniumoxid, Ceroxid, Bornitrid, Diamand, harter Kohlenstoff etc. enthält, allerdings für das Polieren von Si-Wafern. Ziel der JP-A-2001-085373 ist es, abrasive Teilchen mit einem organischen oberflächenaktiven Mittel zu benetzen, um die Teilchen gut in Wasser dispergieren zu können und ein hohes Poliergeschwindigkeitsverhältnis von Siliziumoxidfilm zu Siliziumnitridfilm zu erhalten. Aus dieser Offenbarung läßt sich somit kein Hinweis auf die Lösung des speziellen Problems beim Polieren von III-N-Oberflächen entnehmen.

Das erfindungsgemäße Glätten mit kubischem Bornitrid (cBN) als abrasivem Teilchenmaterial erfolgt vorzugsweise gegenüber der III-polaren (z.B. Ga-polaren) Oberfläche [0001] des III-N-Materials, weil die erfindungsgemäße Wirkungsweise gegenüber dieser chemisch inerten Oberfläche besondere Vorteile bringt. Das erfindungsgemäße Glätten kann jedoch alternativ oder zusätzlich auch gegenüber der N-polaren Oberfläche [0001̅] des III-N-Materials durchgeführt werden.

Eine zum Polieren besonders geeignete Slurry ist eine wasserlösliche Suspension, in der zusätzlich ein oder mehrere Stoffe enthalten sind, die ausgewählt sind aus der aus Ammoniak, Kaliumhydroxid, Natriumhydroxid, Wasserstoffperoxid und organischen Basen bestehenden Gruppe.
In einer bevorzugten Ausführungsform wird ein freistehendes III-N-Substrat oder ein III-N-Template, das ein Fremdsubstrat, eine oberste III-N-Schicht und gegebenenfalls eine oder mehrere Zwischenschicht(en), die aus III-N oder aus einem anderen Material gebildet ist (sind), aufweist, geläppt und/oder poliert. Das Material des Fremdsubstrats wird vorzugsweise ausgewählt aus der aus Saphir, Siliziumkarbid, Galliumnitrid, Aluminiumnitrid, Galliumarsenid, Zinkoxid, Silizium, Lithiumaluminat und Lithiumgallat bestehenden Gruppe.

Um die Kristallqualität insbesondere an der Oberfläche weiter zu verbessern wird in einer bevorzugten Ausführungsform eine Oberfläche eines freistehenden III-N-Substrats mit einer exakt orientierten c-, a-, m- oder r-Ebene oder einer Ebene, die eine Fehlorientierung von 0.1-30° gegenüber einer c-, a-, m- oder r-Ebene aufweist, geläppt und/oder poliert. Es ist weiter von Vorteil, wenn eine Oberfläche mit einer exakt orientierten III-polaren (z.B. Ga-polaren) c-Ebene oder einer Ebene, die eine Fehlorientierung von 0.1-1° gegenüber einer exakt orientierten III-polaren (z.B. Ga-polaren) c-Ebene aufweist, geläppt und/oder poliert wird.

Geeignete mittlere Korngrößen des cBN-Teilchenmaterials liegen zum Beispiel im Bereich von 0.1 bis 20 µm, vorzugsweise im Bereich von 0.5 bis 10 µm und weiter bevorzugt im Bereich von 1 bis 6 µm.

Es ist weiter bevorzugt, vor dem Polierprozess einen Läppprozess durchzuführen. Vorteilhaft ist es, auch beim Läppprozess kubisches Bornitrid als Läppmittel zu verwenden.

Mittels Verwendung des speziell ausgewählten Glättungsmittels cBN ist es möglich, sogar bei größflächigen III-N-Substraten oder III-N-Templaten mit Durchmessern von mindestens 40mm eine einzigartige Kombination von an sich gegenläufigen Eigenschaften zu erreichen, nämlich eine ausgezeichnete Glättung mit extrem guter Homogenität der Oberflächenrauhigkeit zu kombinieren mit einer sehr gut erhaltenen Kristallqualität aufgrund einer geringfügigen, praktisch vernachlässigbaren Kristallschädigung. Ein Maß für die erfindungsgemäß erreichte Kombination von Eigenschaften ist vor allem die Homogenität der extrem geringen Oberflächenrauhigkeit über die gesamte Substrat- bzw. Waferoberfläche. So dient erfindungsgemäß der rms-Wert der Oberflächenrauhigkeit und insbesondere eine homogenen Verteilung des rms-Wertes auf der gesamten Waferoberfläche (ausgenommen eines Randausschlussbereichs von z.B. 5mm) als signifikanter Parameter, messbar beispielsweise durch ein Mapping der Waferoberfläche mit einem Weißlichtinterferometer, wobei die Standardabweichung der rms-Werte ein Maß für die Homogenität der Oberflächenrauhigkeit ist. Erfindungsgemäß werden größflächige III-N-Substrate oder III-N-Template bereitgestellt, bei denen bei einem Mapping auf der geglätteten Oberfläche mittels Weißlichtinterferometrie die Standardabweichung der rms-Werte 5% oder weniger beträgt.

Einen Vergleich zur Bedeutung der erfindungsgemäßen Homogenität der Oberflächenrauhigkeit (erfindungsgemäß angegeben durch die homogene Verteilung des rms-Wertes über die Waferoberfläche) bietet z.B. die oben erwähnte Veröffentlichung Miskys et al.. Auch nach einem aufwendigen Polierverfahren gegenüber der Ga-polaren Oberfläche der GaN-Schicht, welches 4 Polierschritte von jeweils 10 Minuten mit 15, 7, 3 und 0,25 großen Diamantpartikeln und einen weiteren langen Polierschritt mit besonders feinem Poliermaterial (0,04 µm groß) einschloß, blieben gemäß Stand der Technik bei ansonsten relativ glatter Oberfläche mikroskopische Kratzer an der polierten Oberfläche übrig, die dann als vorrangige Nukleationsstellen des GaN-Wachstums wirkten und nach dem epitaxialen Wachstum über diesen Kratzstellen deutlich feststellbare Oberflächendefekte erzeugten.

Als Maß für die gleichzeitig ausgezeichnete Kristallqualität sind insbesondere Messungen aus Rockingkurvenmapping und/oder durch Mikro-Ramanmapping geeignet. So beträgt bei dem freistehenden III-N-Substrat und bei dem III-N-Template bei einem Rockingkurvenmapping auf der durch den erfindungsgemäßen Glättungsprozeß erhaltenen Oberfläche parallel zur Wachstumsebene die Standardabweichung der gemessenen Halbwertsbreiten 5% oder weniger, vorzugsweise 3% oder weniger und weiter bevorzugt 2% oder weniger. Alternativ oder gleichzeitig beträgt bei dem freistehenden III-N-Substrat und dem III-N-Template bei einem Mikro-Ramanmapping auf der durch den erfindungsgemäßen Glättungsprozeß erhaltenen Oberfläche parallel zur Wachstumsebene die Standardabweichung der gemessenen Halbwertsbreiten des E₂-Phonons 5% oder weniger, bevorzugt 3% oder weniger und weiter bevorzugt 2% oder weniger.

Die Standardabweichung kann ermittelt werden, indem bei einer Vielzahl, z.B. bei 100 Messpunkten der zu messenden Oberfläche jeweils Rockingkurvmappingmessungen oder Mikro-Ramanmessungen durchgeführt werden, von allen Messungen der Mittelwert der Halbwertsbreiten gebildet wird und gegenüber diesem Mittelwert über eine übliche statistische Auswertung die Standardabweichung ermittelt wird.

Vorteilhaft können III-N-Substrate oder III-N-Template mit Durchmessern von mindestens 2 Zoll (ca. 5 cm), mindestens 3 Zoll (ca. 7,6 cm) oder mindestens 4 Zoll (ca. 10 cm) oder mehr hergestellt werden.

Entsprechend der bevorzugten Anwendung des erfindungsgemäßen Glättungsprozesses gegenüber der III-polaren (z.B. Ga-polaren) Oberfläche werden bevorzugt III-N-Substrate oder III-N-Template bereitgestellt, bei denen die oben beschriebenen Parameter in Bezug auf Weißlichtinterferometer-Mapping, Rockingkurvenmappings und/oder Mikro-Ramanmappings bezüglich der III-polaren (z.B. Ga-polaren) Oberfläche gelten. Weiter bevorzugt gelten die genannten Parameter jedoch auf beiden Oberflächen, also sowohl auf der III- (z.B. Ga-) als auch auf der N-polaren Oberfläche.

In den obigen Definitionen bedeutet N Stickstoff und III mindestens ein Element der Gruppe III des Periodensystems der Elemente. Das III-Element sollte aus der Gruppe von Elementen, die aus Al, Ga und In besteht, allein oder in Kombination ausgewählt sein. Eine entsprechende allgemeine Formel lautet daher AlₓGa_{y}In_{z}N worin 0≤x≤1, 0≤y≤1, 0≤z≤1 und x+y+z=1. Beispiele für mögliche III-N-Verbindungen sind quaternäre Verbindungen wie (Al,Ga,In)N, ternäre Verbindungen wie (Al,Ga)N, (Ga,In)N und (Al,In)N, oder binäre Verbindungen wie GaN oder AlN. Unter den ausgewählten Elementen der III. Gruppe, wie beispielhaft in den vorstehenden Klammern angegeben, sind alle denkbaren Atomverhältnisse untereinander möglich, d.h. von 0 bis 100 Atom-% für das jeweilige Element (z.B. (Al,Ga)N = AlₓGa₁₋ₓN, wobei 0 ≤ x ≤ 1). (Al,Ga)N und GaN sind besonders bevorzugt. Die nachfolgende Beschreibung eines Beispiels ist nicht nur auf das dort angegebene III-N-Verbindungsbeispiel, sondern auf alle möglichen III-N-Verbindungen anwendbar. Neben den III-N-Substraten ist die Erfindung günstig auch auf ein III-N-Template anwendbar, das ein oben erwähntes Fremdsubstrat, eine oberste III-N-Schicht und gegebenenfalls eine oder mehrere Zwischenschicht(en), die aus III-N oder aus einem anderen Material gebildet ist (sind), aufweist und dessen III-N-Oberfläche entsprechend geglättet ist. Die Zusammensetzungen von III-N für dünne und für dicke Schichten, Substrate und Templates können unabhängig gewählt werden. Die Zusammensetzungen können gleich oder verschieden sein. Die Erfindung ist besonders geeignet anwendbar auf III-N-Schichten, -Substrate und -Templates, die mittels Epitaxie-Verfahren hergestellt wurden, bevorzugt mittels Gasphasenepitaxie wie mittels MOVPE und vor allem mittels HVPE. Das III-N-Verbindungsmaterial ist vorteilhafterweise kristallin und vor allem einkristallin.

Beschreibung von bevorzugten Ausführungsformen und Beispielen

Die Erfindung wird nachfolgend anhand von bevorzugten Ausführungsformen und Beispielen, die jedoch nur zur Veranschaulichung und nicht einschränkend zu verstehen sind, unter Bezugnahme auf die beigefügte Zeichnung näher beschrieben, wobei
Fig. 1 einen Vergleich der Oberflächenrauhigkeit (rms-Wert) eines GaN-Wafers zeigt nach einem mechanischen Polieren mit cBN-haltigem Slurry (Erfindung) und mit Diamanthaltigem Slurry (Vergleich), und
Fig. 2 ein Prinzip für eine Oberflächenuntersuchung zeigt, die zur Messung von rms-Werten mittels Weißlichtinterferometrie geeignet ist.

Der Poliervorgang kann auf einer handelsüblichen Poliermaschine stattfinden, wobei während des Polierens in einer möglichen Ausführungsform die Trägerplatte und der/die darauf befestigte(n) Wafer rotieren sowie zusätzlich der/die Wafer eine oszillatorische Bewegung in radialer Richtung ausführt/ausführen. Polierteller mit dem darauf befestigten Poliertuch und Wafer werden während des Polierens aneinandergedrückt, wobei die Slurry auf das Poliertuch zugetropft wird.

Die Slurry ist eine Dispersion auf wässriger Basis mit cBN als abrasivem Teilchen. Um optimal glatte Oberflächen zu erhalten, werden mehrere Polierschritte durchgeführt, wobei die mittlere Korngröße von cBN bei jedem nachfolgenden Polierschritt abnimmt. Eine mögliche Abstufung sind beispielsweise mittlere Korngrößen von 6µm, 3µm und 1µm in drei aufeinanderfolgenden Polierschritten.

Das Poliertuch kann optional während bzw. alternativ vor und zwischen den Polierfahrten konditioniert werden (beispielsweise mit ,DiaGrid' Pad conditioner von Rohm and Haas, Feldkirchen, Germany).

Die zu polierenden (Al,Ga,In)N-Wafer oder -Templates können durch verschiedene bekannte Gasphasen- oder Lösungszüchtungsmethoden hergestellt werden. Direkt nach dem Wachstumsschritt können weitere mechanische Bearbeitungsschritte (einer oder mehrere) ausgewählt aus den nachfolgend genannten Schritten dem Polierprozess vorangestellt sein:
- Rundschleifen,
- Schleifen von Flats und/oder Notches
- Drahtsägen,
- Kantenverrunden,
- Läppen,

wobei der letztgenannte Läppschritt aus mehreren aufeinanderfolgenden Teilschritten mit abnehmender mittlerer Körnung des Läppmittels bestehen kann. Als Läppmittel kann beispielsweise Siliziumkarbid, Diamant oder kubisches Bornitrid verwendet werden.

Zum Mapping der Waferoberfläche mit einem Weißlichtinterferometer, wobei die Standardabweichung der rms-Werte als Maß für die Homogenität der Oberflächenrauhigkeit dienen kann, kann beispielsweise die Waferoberfläche in ein Raster mit jeweils maximal 5 mm Abstand in zwei zueinander orthogonalen Richtungen eingeteilt werden. Unter Beachtung eines Randausschlussbereichs von 5 mm kann nun in jedem Raster ein Oberflächenscan durchgeführt werden, wobei der Scanbereich wenigstens 1% der Rastergröße betragen sollte. Die rms-Werte können standardmäßig mit einem kommerziell erhältlichen Weißlichtinterferometer unter Verwendung von Weißlicht gemessen werden.

Die Kristallqualität der behandelten Oberfläche lässt sich messtechnisch erfassen beispielsweise mittels Röntgenbeugung z.B. als räumliche Verteilung der Absolutlagen und/oder Halbwertsbreiten von Röntgenbeugungskurven entsprechend der Beugung an bestimmten Netzebenenscharen. Die Homogenität der Kristallqualität in der Wachstumsebene kann man beispielsweise an Hand eines sogenannten RockingkurvenMappings (Aufnehmen von ω-Scans an verschiedenen Probenstellen der Oberfläche), welches in einer Ebene parallel zur Wachstumsebene aufgenommen wurde, festmachen. Im Falle eines in [0001]-Richtung gewachsenen Kristalls kann man bei den ω-Scans z.B. die Reflexion der (0002)-Netzebenen nutzen. Die Homogenität der Kristallqualität in Wachstumsrichtung kann an Hand der Standardabweichung der Mittelwerte der Halbwertsbreiten der (0002) ω-Scans der einzelnen Substrate, die aus dem entsprechenden Bulkkristall gewonnen wurden, bestimmt werden.

Eine zweite Methode zur Bestimmung der Homogenität der Kristallqualität sind Mikro-Ramanmappings. So sind beispielsweise die Standardabweichungen von Frequenz und Halbwertsbreite des E₂-Phonons bei einem Scan auf der Oberfläche parallel zur Wachstumsebene ein Maß für die Homogenität der Kristallqualität parallel zur Wachstumsebene.

Die Mikro-Ramanmessungen können mit einer Laseranregungswellenlänge von 532 nm (Frequenzverdoppelter Nd:YAG-Laser), einer Anregungsleistung von 3 mW (z.B. mit einem Labram800HR Spektrometer von Jobin Yvon) durchgeführt werden, wobei die Laserlinie mit Hilfe einer Mikroskopoptik auf einen Strahldurchmesser von ∼ 1µm auf der Probe fokussiert werden kann. Bei dem Scan auf der Oberfläche beträgt die Schrittweite in x- und y-Richtung zum Beispiel ∼2,5mm. Es wird ein passender Randausschlussbereich gewählt, zum Beispiel 2mm vom Waferrand. Bei dem Scan auf der senkrecht zur Oberfläche liegenden Spaltfläche des Wafers beträgt die Schrittweite in z-Richtung ∼10µm. Frequenz und Halbwertsbreite des E₂-Phonons werden durch Lorentz-Linienformanalysen bestimmt.

### Ausführungsbeispiel:

Als Poliermaschine kam eine PT 350 Premium der Fa. I-B-S Fertigungs- und Vertriebs-GmbH zum Einsatz. GaN-Wafer mit (0001)-Orientierung wurden mit der N-polaren Rückseite mittels Thermowax auf eine erhitzte Trägerplatte aufgeklebt, wobei Letztere bis zum Prozessbeginn wieder auf Raumtemperatur abgekühlt war. Das Poliertuch, ein mittelhartes Tuch auf Polyurethanbasis (Rohm and Haas SUBA IV), wurde auf den Polierteller aufgeklebt. Die cBN-Slurry (CBN Slurry W69S1 6µm/3µmHVY, Handelsagentur Manfred Böduel, Wittenberg, Germany) wurde mit einer Flussrate von ∼5 ml/min zugetropft. Die Anwendung der cBN-Slurry erfolgte in zwei unabhängig voneinander ablaufenden Polierstufen mit der Verwendung von jeweils 6µm bzw. 3µm großen cBN-Partikeln (jeweils mittlere Partikelgröße). Polierteller und Probe rotierten mit ∼30 min⁻¹ bzw. ∼20 min⁻¹. Darüberhinaus oszillierte die azentrisch befestigte Probe in radialer Richtung. Der Polierdruck lag bei ∼1700 g/cm².
Die Ga-polaren Oberflächen derart polierter Wafer wurden mittels eines kommerziellen Weißlichtinterferometers (Zygo New View) mit den Ga-polaren Oberflächen von Wafern verglichen, die unter sonst gleichen Bedingungen mit einer Diamant-Slurry (mittlere Korngrößen 6 µm und 3 µm) poliert wurden. Die Meßdurchführung ist unten näher beschrieben.

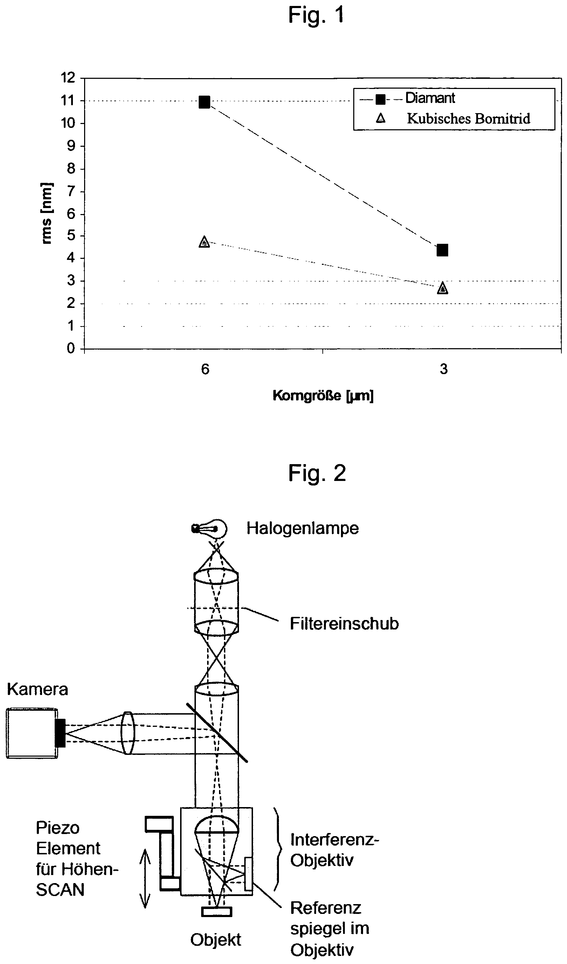

Fig. 1 zeigt einen Vergleich der mittleren Oberflächenrauhigkeit (rms-Wert) nach der mechanischen Politur mit cBN- und Diamant-Slurry.

Wie Fig. 1 zu entnehmen ist, erreicht man nach beiden Polierstufen mit der cBN-Slurry deutlich niedrigere Oberflächenrauhigkeiten und vor allem eine geringere Standardabweichung der absoluten rms-Werte gegenüber dem Mittelwert im Vergleich zur Diamant-Slurry. Dabei wurden die rms-Werte auf einer Fläche von 350 x 260 µm² gemessen.

Analyse der GaN-Oberflächen, speziell zur Rauhigkeitsmessung mit Standardmessung von rms-Werten mittels kommerziellem Weißlichtinterferometer (Zygo New View).
Ein Prinzip eines Weißlichtinterferometers ist in Fig. 2 gezeigt (Quelle: zygoLOT).
Das Messprinzip beruht auf der Kombination eines Mikroskops mit einem Interferometer. Hierbei wird das Licht einer Weißlichtquelle in zwei Strahlengänge unterteilt, wobei ein Teilstrahl an einem Referenzspiegel und der andere an der Probe reflektiert wird. Anschließend werden beide zur Überlagerung gebracht. Durch die Topographie der Probenoberfläche kommt es zu unterschiedlichen optischen Weglängen beider Strahlen und damit zu einem Interferenzmuster, dessen Auswertung mittels Frequenz Domänen Analyse (FDA) erfolgt. Die Verwendung von Weißlicht gestattet die Auswertung der Interferenzen mehrerer Lichtwellenlängen. Die relative Position zwischen Referenzspiegel und Probenoberfläche kann mittels Piezoaktor verfahren werden.

Aus der Korrelation der hochgenau bekannten Wegänderung zwischen Spiegel und Probe mit der Auswertung des Interferenzsignals werden vertikale Genauigkeiten bis 0,1 nm erzielt. Eine Probenreflektivität von 0,4 % ist für die Messung ausreichend, so dass auch gering reflektierende Oberflächen gemessen werden können.

Mikro-Ramanmessungen zur Bestimmung Frequenz und Halbwertsbreite des E₂-Phonons können mit einem kommerziellen Labram800HR Spektrometer von Jobin Yvon wie folgt durchgeführt werden:
- Laseranregungswellenlänge 532 nm (Frequenzverdoppelter Nd:YAG-Laser),
- Anregungsleistung 3 mW
- Fokussierung der Laserlinie mit Hilfe einer Mikroskopoptik auf einen Strahldurchmesser von ∼ 1µm auf die Probe
Das Spektrometer wird zusätzlich mit Hilfe von Ne-Plasmalinien kalibriert. Die Messungen werden in Rückstreugeometrie durchgeführt, wobei die Polarisatorstellungen derart gewählt werden, daß die E₂-Phonon detektiert werden können [Scan auf Oberfläche: z(y x/y)-z; Scan auf Spaltfläche: y(x x)-y]. Bei dem Scan auf der Oberfläche beträgt die Schrittweite in x- und y-Richtung ∼2,5mm. Der Randausschlussbereich beträgt 2mm vom Waferrand. Bei dem Scan auf der senkrecht zur Oberfläche liegenden Spaltfläche des Wafers beträgt die Schrittweite in z-Richtung ∼10µm. Frequenz und Halbwertsbreite des E₂-Phonons werden durch Lorentz-Linienformanalysen bestimmt.

## Patentansprüche

1. Verfahren zum Herstellen einer geglätteten Oberfläche eines Materials, das an der zu glättenden Oberfläche eine III-N-Verbindung umfaßt, wobei III mindestens ein Element der Gruppe III. des Periodensystems bedeutet, ausgewählt aus Al, Ga und In, wobei das Verfahren einen Polierprozess der Oberfläche des III-N-Materials einschließt, mit Hilfe eines abrasive Teilchen umfassenden Glättungsmittels in Form einer Slurry-Dispersion auf wässriger Basis, wobei das Material der verwendeten abrasiven Teilchen der Slurry kubisches Bornitrid ist, und **dadurch gekennzeichnet, dass** der Polierprozeß mehrere Schritte einschließt, bei denen in jeweils nachfolgenden Schritten die mittlere Korngröße der kubischen Bornitridteilchen abnimmt.

2. Verfahren nach Anspruch 1, umfassend einen Schritt des Polierens mit der Slurry, wobei die Slurry eine Suspension auf wässriger Basis ist, in der zusätzlich ein oder mehrere Stoffe enthalten sind, die ausgewählt sind aus der aus Ammoniak, Kaliumhydroxid, Natriumhydroxid, Wasserstoffperoxid und organischen Basen bestehenden Gruppe.

3. Verfahren nach Anspruch 1 oder 2, wobei ein freistehendes III-N-Substrat oder ein III-N-Template, das ein Fremdsubstrat, eine oberste III-N-Schicht und gegebenenfalls eine oder mehrere Zwischenschicht(en), die aus III-N oder aus einem anderen Material gebildet ist (sind), aufweist, geläppt und/oder poliert wird.

4. Verfahren gemäß Anspruch 3, wobei das Material des Fremdsubstrats ausgewählt ist aus der aus Saphir, Siliziumkarbid, Galliumnitrid, Aluminiumnitrid, Galliumarsenid, Zinkoxid, Silizium, Lithiumaluminat und Lithiumgallat bestehenden Gruppe.

5. Verfahren nach Anspruch 3 oder 4, wobei eine Oberfläche eines freistehenden III-N-Substrats mit einer exakt orientierten c-, a- ,m- oder r-Ebene oder einer Ebene, die eine Fehlorientierung von 0.1-30° gegenüber einer c-, a- ,m- oder r-Ebene aufweist, und vorzugsweise eine Oberfläche mit einer exakt orientierten III-polaren c-Ebene oder einer Ebene, die eine Fehlorientierung von 0.1-1° gegenüber einer exakt orientierten III-polaren c-Ebene aufweist, geläppt und/oder poliert wird.

6. Verfahren nach Anspruch 1, wobei in drei aufeinanderfolgenden Schritten die mittleren Korngrößen jeweils über 4 bis 7 µm, 2 bis unter 4 µm und 0,5 bis unter 2 µm betragen.

7. Verfahren nach Anspruch 1, wobei in drei aufeinanderfolgenden Schritten die mittleren Korngrößen jeweils etwa 6 µm, etwa 3 µm und etwa 1 µm betragen.

8. Verfahren nach einem der vorangehenden Ansprüche, wobei vor dem Polierprozess ein Läppprozess durchgeführt wird, wobei als Läppmittel kubisches Bornitrid verwendet wird.

9. Verfahren nach einem der vorangehenden Ansprüche, wobei die Slurry mit kubischem Bornitrid als Glättungsmittel auf die III-polare Oberfläche [0001] des III-N-Materials angewendet wird.

## Claims

1. Process for the preparation of a smooth surface of a material comprising a III-N-compound on a surface to be smoothed, wherein III denotes at least one element of the group III of the periodic table, selected from Al, Ga and In, wherein the process includes a polishing procedure of the surface of the III-N-material, by means of a smoothing means comprising abrasive particles in the form of an aqueous slurry-dispersion, **characterized in that** the material of the used abrasive particles of the slurry is cubic boron nitride, and that the polishing procedure includes multiple steps, in which the average particle size of the cubic boron nitride particles decreases in respectively subsequent steps.

2. Process according to claim 1, comprising a step of polishing with the slurry, wherein the slurry is an aqueous suspension, which additionally includes one or more substances selected from the group consisting of ammonia, potassium hydroxide, sodium hydroxide, hydrogen peroxide and organic bases.

3. Process according to claim 1 or 2, wherein a free-standing III-N-substrate or a III-N-template, which comprises a foreign substrate, an upper III-N-layer and optionally one or more intermediate layer(s) formed of III-N or another material, is lapped and/or polished.

4. Process according to claim 3, wherein the material of the foreign substrate is selected from the group consisting of sapphire, silicon carbide, gallium nitride, aluminum nitride, gallium arsenide, zinc oxide, silicon, lithium aluminate and lithium gallate.

5. Process according to claim 3 or 4, wherein a surface of a free-standing III-N-substrate with an exactly oriented c-, a-, m- or r-plane or a plane comprising a misorientation of 0.1-30° relative to a c-, a-, m- or r-plane, and preferably a surface with an exactly oriented III-polar c-plane or a plane comprising a misorientation of 0.1-1° relative to an exactly oriented III-polar c-plane, is lapped and/or polished.

6. Process according to claim 1, wherein the average particle sizes in three subsequent steps are respectively above 4 up to 7 µm, 2 to below 4 µm and 0.5 to below 2 µm.

7. Process according to claim 1, wherein the average particle sizes in three subsequent steps are respectively approximately 6 µm, approximately 3 µm and approximately 1 µm.

8. Process according to one of the previous claims,
wherein a lapping procedure is performed before the polishing procedure, wherein cubic boron nitride is used as lapping means.

9. Process according to one of the previous claims,
wherein the slurry with cubic boron nitride is used as smoothing means on the III-polar surface [0001] of the III-N-material.

## Revendications

1. Procédé de fabrication d'une surface lisse d'un matériau comprennant un composé de III-N sur la surface à lisser, dans lequel III représente au moins un élément du groupe III du système périodique choisi parmi Al, Ga et In, dans lequel le procédé inclut une opération de polissage de la surface du matériau de III-N à l'aide d'un moyen de lissage contenant des particules abrasives sous la forme d'une dispersion en suspension à base aqueuse, dans lequel le matériau des particules abrasives utilisées de la suspension est le nitrure de bore cubique, et **caractérisé en ce que** l'opération de lissage inclut plusieurs étapes lors desquelles la granulométrie moyenne des particules de nitrure de bore cubique diminue à chacune des étapes suivantes.

2. Procédé selon la revendication 1, comprenant une étape de polissage avec la suspension, dans lequel la suspension est une suspension à base aqueuse contenant en outre une ou plusieurs substances choisies dans le groupe constitué de l'ammoniac, de l'hydroxyde de potassium, de l'hydroxyde de sodium, du peroxyde d'hydrogène et de bases organiques.

3. Procédé selon la revendication 1 ou 2, dans lequel un substrat de III-N dégagé ou une matrice de III-N qui comprend un substrat étranger, une couche de III-N supérieure et le cas échéant une ou plusieurs couches intermédiaires constituées de III-N ou d'un autre matériau est rodé et/ou poli.

4. Procédé selon la revendication 3, dans lequel le matériau du substrat étranger est choisi dans le groupe constitué du saphir, du carbure de silicium, du nitrure de gallium, du nitrure d'aluminium, de l'arséniure de gallium, de l'oxyde de zinc, du silicium, de l'aluminate de lithium et du gallate de lithium.

5. Procédé selon la revendication 3 ou 4, dans lequel une surface du substrat de III-N dégagé ayant un plan c, a, m ou r orienté exactement ou un plan qui présente une désorientation de 0,1 à 30° par rapport à un plan c, a, m ou r, et de préférence une surface ayant un plan c polaire pour III orienté exactement ou un plan qui présente une désorientation de 0,1 à 1° par rapport à un plan c polaire pour III orienté exactement, est rodée et/ou polie.

6. Procédé selon la revendication 1, dans lequel en trois étapes successives, les granulométries moyennes ont respectivement environ de 4 à 7 µm, 2 à moins de 4 µm et 0,5 à moins de 2 µm.

7. Procédé selon la revendication 1, dans lequel en trois étapes successives, les granulométries moyennes atteignent respectivement environ 6 µm, environ 3 µm et environ 1 µm.

8. Procédé selon l'une des revendications précédentes, dans lequel une opération de rodage est effectuée avant l'opération de polissage, dans laquelle le nitrure de bore cubique est utilisé comme moyen de rodage.

9. Procédé selon l'une des revendications précédentes, dans lequel la suspension comprenant du nitrure de bore cubique comme moyen de lissage est appliquée sur la surface [0001] du matériau de III-N polaire pour III.
